# EUROPEAN PATENT SPECIFICATION

(11) **EP 4 542 856 B1**
(45) Date of publication and mention of the grant of the patent: **01.07.2026**
(21) Application number: 22954915.9
(22) Date of filing: 09.08.2022
(51) Int. Cl.: H03F 1/32, H04L 27/36, H03F 3/189, H03F 3/24

(54) **DISTORTION COMPENSATION DEVICE, DISTORTION COMPENSATION METHOD, AND TRANSMISSION DEVICE**
VERZERRUNGSKOMPENSATIONSVORRICHTUNG, VERZERRUNGSKOMPENSATIONSVERFAHREN UND ÜBERTRAGUNGSVORRICHTUNG
DISPOSITIF DE COMPENSATION DE DISTORSION, PROCÉDÉ DE COMPENSATION DE DISTORSION ET DISPOSITIF DE TRANSMISSION

(43) Date of publication of application: 23.04.2025
(73) Proprietor: MITSUBISHI ELECTRIC CORPORATION, Chiyoda-ku Tokyo 100-8310 (JP)
(72) Inventor: YAMASHITA, Ao, Tokyo 100-8310 (JP); SAKAKI, Hiroto, Tokyo 100-8310 (JP); NAKAMIZO, Hideyuki, Tokyo 100-8310 (JP)
(74) Representative: Pfenning, Meinig & Partner mbB
(86) International application number: PCT/JP2022/030351
(87) International publication number: WO 2024/033993

(56) References cited:
- JP-A- 2008 131 186
- JP-A- 2011 176 689
- JP-A- 2020 537 847
- US-A1- 2019 068 429
- US-A1- 2021 203 282
- US-A1- 2021 391 832
- US-A1- 2021 391 832

## Description

### TECHNICAL FIELD

The present disclosure relates to a distortion compensation device, a distortion compensation method, and a transmission device.

### BACKGROUND ART

There is a transmission device including a power amplifier that amplifies power of a transmission signal. A non-linear characteristic of the power amplifier may generate distortion in an amplification target signal after power amplification by the power amplifier. For example, Non-Patent Literature 1 discloses a distortion compensation device for compensating distortion generated in a transmission signal after power amplification by a power amplifier. The distortion compensation device includes a distortion compensation unit that gives a transmission signal to be power-amplified to a neural network (hereinafter, referred to as a "learning model") and acquires, from the learning model, a predistortion signal for compensating distortion generated in the transmission signal after power amplification by the power amplifier. The distortion compensation unit outputs the predistortion signal to the power amplifier as the transmission signal.
US2021203282A1 discloses a radio frequency, RF, transmit system for a magnetic resonance examination system, comprising a digital baseband modulator configured for generating a digital baseband signal, a digital feedback control loop configured for injecting a digital pre-distortion signal into the digital baseband signal, an RF amplifier configured for being driven by the pre-distorted digital base band signal and for providing an analog output signal, wherein the digital feedback control loop is configured for controlling the digital pre-distortion signal based on the analog output signal to compensate a non-linearity of the RF amplifier.
US2021391832A1 discloses machine learning based digital pre-distortion for power amplifiers. A device may amplify a signal with a power amplifier and transmit the signal. The signal may be received by an internal feedback receiver of the device. The device may further comprise a first machine learning model configured to emulate an external feedback receiver and to generate an emulated feedback signal based on the internal feedback signal.
US2019068429A1 discloses digital predistortion (DPD) for use with a multi-chain wireless transmitter. In various examples described herein, the multi-chain transmitter is configured to use a single common DPD device or module for all transmit chains and to adjust the bias voltages of the power amplifiers of the separate transmit chains to operate at substantially the same backoff so the distortion to the corresponding output signals is similar. Since the distortion of the output of the different chains is similar, a single common predistortion may be applied using the single DPD device to a signal to be transmitted.

### CITATION LIST

### NON-PATENT LITERATURE

Non-Patent Literature 1: Slim Boumaiza, and Farouk Mkadem, "Wideband RF Power Amplifier Predistortion using Real-Valued Time-Delay Neural Networks", European Microwave Conference (EuMC), 2009.

### SUMMARY OF INVENTION

### TECHNICAL PROBLEM

By change of an operation status of a power amplifier, distortion generated in a transmission signal after power amplification by the power amplifier changes. Examples of the operation status of the power amplifier include an ambient temperature of the power amplifier, a carrier frequency of the transmission signal, and a bias voltage of the power amplifier.

In the distortion compensation device disclosed in Non-Patent Literature 1, an operation status of the power amplifier at the time of training of the learning model may be different from an operation status of the power amplifier when the distortion compensation unit acquires the predistortion signal from the learning model. As described above, when there is a difference in the operation status of the power amplifier, there is a difference in the distortion generated in the transmission signal after power amplification by the power amplifier. For this reason, even when the distortion compensation unit outputs, as the transmission signal, the predistortion signal acquired from the learning model to the power amplifier, there is a problem that the distortion generated in the transmission signal after power amplification by the power amplifier may not be compensated.

The present disclosure has been made in order to solve the problem as described above, and an object of the present disclosure is to obtain a distortion compensation device capable of compensating distortion generated in a signal after power amplification by a power amplifier even when an operation status of the power amplifier changes.

### SOLUTION TO PROBLEM

The distortion compensation device according to the present disclosure includes: an amplification target signal acquiring unit to acquire an amplification target signal which is a signal to which power amplification by a power amplifier is performed; an operation status signal acquiring unit to acquire an operation status signal indicating an operation status of the power amplifier; and a distortion compensation unit to acquire a signal in which distortion is added to the amplification target signal acquired by the amplification target signal acquiring unit as a predistortion signal for performing compensation of distortion generated in the amplification target signal after the power amplification by the power amplifier on a basis of the amplification target signal acquired by the amplification target signal acquiring unit and the operation status signal acquired by the operation status signal acquiring unit, and to output the predistortion signal to the power amplifier, wherein the distortion compensation unit gives, when the amplification target signal and the operation status signal are input, the amplification target signal acquired by the amplification target signal acquiring unit and the operation status signal acquired by the operation status signal acquiring unit to a learning model being trained to output a signal to which distortion for compensating distortion generated in the amplification target signal after the power amplification is performed, and acquires the predistortion signal estimated by the learning model without training the learning model, the learning model is implemented by a neural network, and in training, a time-series signal of the amplification target signal acquired by the amplification target signal acquiring unit, the operation status signal acquired by the operation status signal acquiring unit, and the predistortion signal are given to the learning model as training data, the learning model is trained to output the predistortion signal corresponding to the time-series signal of the amplification target signal and the operation status signal which have been input by calculating a weight addition of the time-series signal of the amplification target signal and the operation status signal on a basis of weight coefficients determined by learning of the predistortion signal included in the training data, and the distortion compensation unit generates, when the amplification target signal is input, a time-series signal of the amplification target signal by delaying the amplification target signal by a predetermined sampling time in order, gives the time-series signal of the amplification target signal being generated and the operation status signal to the learning model, and acquires the predistortion signal estimated by the learning model.

### ADVANTAGEOUS EFFECTS OF INVENTION

According to the present disclosure, even when an operation status of the power amplifier changes, distortion generated in a signal after power amplification by the power amplifier can be compensated.

### BRIEF DESCRIPTION OF DRAWINGS

FIG. 1 is a configuration diagram illustrating a transmission device including a distortion compensation device 2 according to a first embodiment.
FIG. 2 is a hardware configuration diagram illustrating hardware of the distortion compensation device 2 according to the first embodiment.
FIG. 3 is a hardware configuration diagram of a computer in a case where the distortion compensation device 2 is implemented by software, firmware, or the like.
FIG. 4 is a flowchart illustrating a distortion compensation method which is a processing procedure performed by the distortion compensation device 2.
FIG. 5 is an explanatory diagram illustrating configuration examples of a distortion compensation unit 25 and a learning model 24.
FIG. 6 is a configuration diagram illustrating a transmission device including a distortion compensation device 2 according to a second embodiment.
FIG. 7 is a hardware configuration diagram illustrating hardware of the distortion compensation device 2 according to the second embodiment.
FIG. 8 is a configuration diagram illustrating a transmission device including a distortion compensation device 2 according to a third embodiment.
FIG. 9 is a hardware configuration diagram illustrating hardware of the distortion compensation device 2 according to the third embodiment.
FIG. 10 is an explanatory diagram illustrating details of signal value adjustment performed by a signal value adjusting unit 27.
FIG. 11 is a configuration diagram illustrating an example of a transmission device including the distortion compensation device 2.

### DESCRIPTION OF EMBODIMENTS

Hereinafter, in order to describe the present disclosure in more detail, embodiments for carrying out the present disclosure will be described with reference to the attached drawings.

### First Embodiment.

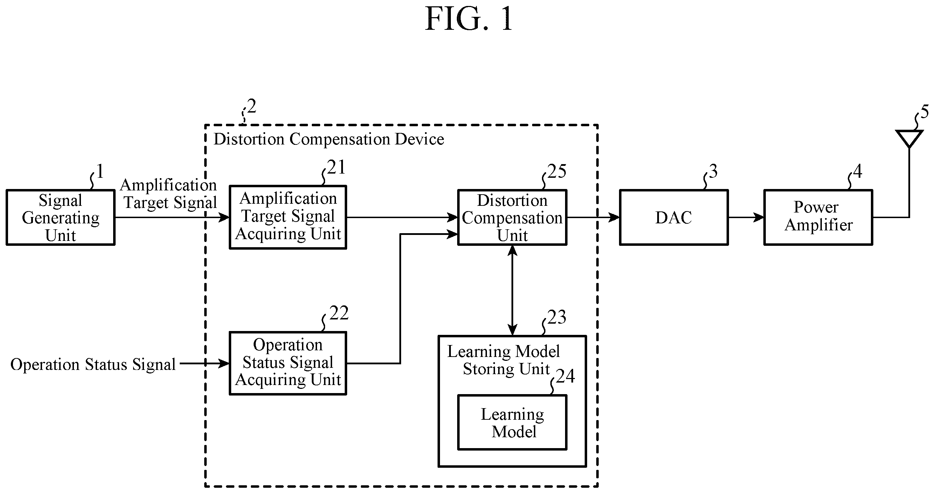

FIG. 1 is a configuration diagram illustrating a transmission device including a distortion compensation device 2 according to a first embodiment.

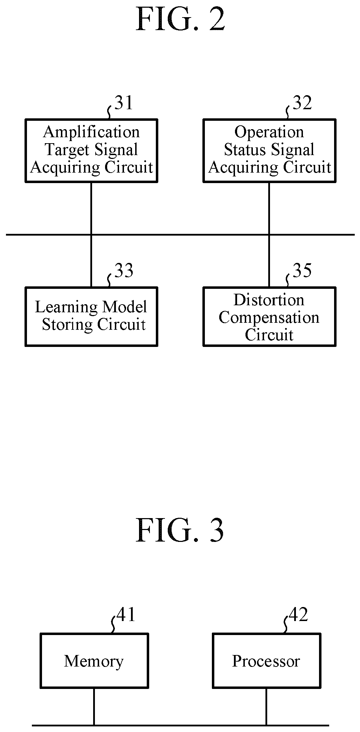

FIG. 2 is a hardware configuration diagram illustrating hardware of the distortion compensation device 2 according to the first embodiment.

The transmission device illustrated in FIG. 1 includes a signal generating unit 1, the distortion compensation device 2, a digital-to-analog converter (hereinafter, referred to as "DAC") 3, a power amplifier 4, and a transmission antenna 5.

The signal generating unit 1 generates an amplification target signal which is a signal to be power-amplified by the power amplifier 4. The amplification target signal is, for example, a radio frequency (RF) transmission signal.

When a frequency converter that converts an intermediate frequency (IF) baseband signal to an RF transmission signal is disposed at a preceding stage of the power amplifier 4, the amplification target signal may be an IF baseband signal.

The signal generating unit 1 outputs the amplification target signal to the distortion compensation device 2.

The distortion compensation device 2 includes an amplification target signal acquiring unit 21, an operation status signal acquiring unit 22, a learning model storing unit 23, and a distortion compensation unit 25.

The distortion compensation device 2 acquires the amplification target signal from the signal generating unit 1.

The distortion compensation device 2 adds distortion capable of compensating distortion generated in the amplification target signal after power amplification by the power amplifier 4 to the amplification target signal.

The distortion compensation device 2 outputs a predistortion signal, which is an amplification target signal after distortion addition, to the power amplifier 4 via the DAC 3.

The DAC 3 converts the predistortion signal output from the distortion compensation device 2 from a digital signal to an analog signal.

The DAC 3 outputs the analog predistortion signal to the power amplifier 4.

The power amplifier 4 amplifies power of the analog predistortion signal output from the distortion compensation device 2.

The power amplifier 4 outputs, as a transmission signal, the predistortion signal after power amplification to the transmission antenna 5.

The transmission antenna 5 emits a radio wave related to the transmission signal output from the power amplifier 4 into space.

The amplification target signal acquiring unit 21 is implemented by, for example, an amplification target signal acquiring circuit 31 illustrated in FIG. 2.

The amplification target signal acquiring unit 21 acquires the amplification target signal from the signal generating unit 1.

The amplification target signal acquiring unit 21 outputs the amplification target signal to the distortion compensation unit 25.

The operation status signal acquiring unit 22 is implemented by, for example, an operation status signal acquiring circuit 32 illustrated in FIG. 2.

The operation status signal acquiring unit 22 acquires an operation status signal indicating an operation status of the power amplifier 4.

The operation status signal acquiring unit 22 outputs the operation status signal to the distortion compensation unit 25. The operation status signal is a stationary signal having a smaller temporal change in signal value than the amplification target signal.

The operation status signal is, for example, temperature information indicating an ambient temperature of the power amplifier 4, frequency information indicating a carrier frequency of the amplification target signal acquired by the amplification target signal acquiring unit 21, bias voltage information indicating a bias voltage of the power amplifier 4, or backoff information indicating backoff of the power amplifier 4.

When the ambient temperature of the power amplifier 4 changes, distortion generated in the amplification target signal after power amplification by the power amplifier 4 changes. When the carrier frequency of the amplification target signal changes, the distortion generated in the amplification target signal after power amplification by the power amplifier 4 changes. When the bias voltage of the power amplifier 4 changes, the distortion generated in the amplification target signal after power amplification by the power amplifier 4 changes. When the backoff of the power amplifier 4 changes, the distortion generated in the amplification target signal after power amplification by the power amplifier 4 changes.

The learning model storing unit 23 is implemented by, for example, a learning model storing circuit 33 illustrated in FIG. 2.

The learning model storing unit 23 stores a learning model 24.

The distortion compensation device 2 illustrated in FIG. 1 includes the learning model storing unit 23. However, this is merely an example, and the learning model storing unit 23 may be disposed outside the distortion compensation device 2.

The learning model 24 is implemented by, for example, a neural network.

To the learning model 24, at the time of training, the amplification target signal acquired by the amplification target signal acquiring unit 21, the operation status signal acquired by the operation status signal acquiring unit 22, and the predistortion signal capable of compensating distortion generated in the amplification target signal after power amplification by the power amplifier 4 are given as training data.

The learning model 24 is a trained model in which the predistortion signal included in the training data has been learned.

The distortion compensation unit 25 is implemented by, for example, a distortion compensation circuit 35 illustrated in FIG. 2.

The distortion compensation unit 25 estimates a signal in which distortion is added to the amplification target signal acquired by the amplification target signal acquiring unit 21 as the predistortion signal for compensating distortion generated in the amplification target signal after power amplification by the power amplifier 4 on the basis of the amplification target signal acquired by the amplification target signal acquiring unit 21 and the operation status signal acquired by the operation status signal acquiring unit 22.

Specifically, the distortion compensation unit 25 gives the amplification target signal acquired by the amplification target signal acquiring unit 21 and the operation status signal acquired by the operation status signal acquiring unit 22 to the learning model 24.

The distortion compensation unit 25 acquires, from the learning model 24, a signal in which distortion is added to the amplification target signal acquired by the amplification target signal acquiring unit 21 as the predistortion signal for compensating distortion generated in the amplification target signal after power amplification by the power amplifier 4.

The distortion compensation unit 25 outputs the predistortion signal to the power amplifier 4 via the DAC 3.

In the distortion compensation device 2 illustrated in FIG. 1, the distortion compensation unit 25 estimates the predistortion signal for compensating distortion generated in the amplification target signal after power amplification by the power amplifier 4 using the learning model 24. However, this is merely an example, and the distortion compensation unit 25 may estimate the predistortion signal for compensating distortion generated in the amplification target signal after power amplification by the power amplifier 4 using, for example, a rule base. In the rule base, a rule for determining predistortion signals corresponding to the amplification target signal acquired by the amplification target signal acquiring unit 21 and the operation status signal acquired by the operation status signal acquiring unit 22 is described.

In FIG. 1, it is assumed that each of the amplification target signal acquiring unit 21, the operation status signal acquiring unit 22, the learning model storing unit 23, and the distortion compensation unit 25, which are constituent elements of the distortion compensation device 2, is implemented by dedicated hardware as illustrated in FIG. 2. That is, it is assumed that the distortion compensation device 2 is implemented by the amplification target signal acquiring circuit 31, the operation status signal acquiring circuit 32, the learning model storing circuit 33, and the distortion compensation circuit 35.

To the learning model storing circuit 33, a nonvolatile or volatile semiconductor memory such as a random access memory (RAM), a read only memory (ROM), a flash memory, an erasable programmable read only memory (EPROM), or an electrically erasable programmable read only memory (EEPROM), a magnetic disk, a flexible disk, an optical disc, a compact disc, a mini disc, or a digital versatile disc (DVD) corresponds.

To each of the amplification target signal acquiring circuit 31, the operation status signal acquiring circuit 32, and the distortion compensation circuit 35, a single circuit, a composite circuit, a programmed processor, a parallel programmed processor, an application specific integrated circuit (ASIC), a field-programmable gate array (FPGA), or a combination thereof corresponds.

The constituent elements of the distortion compensation device 2 are not limited to those implemented by dedicated hardware, and the distortion compensation device 2 may be implemented by software, firmware, or a combination of software and firmware.

Software or firmware is stored as a program in a memory of a computer. The computer means hardware for executing a program. To the computer, for example, a central processing unit (CPU), a central processing device, a processing device, an arithmetic device, a microprocessor, a microcomputer, a processor, or a digital signal processor (DSP) corresponds.

FIG. 3 is a hardware configuration diagram of a computer in a case where the distortion compensation device 2 is implemented by software, firmware, or the like.

In a case where the distortion compensation device 2 is implemented by software, firmware, or the like, the learning model storing unit 23 is constituted on a memory 41 of the computer. A program for causing the computer to execute a processing procedure performed in each of the amplification target signal acquiring unit 21, the operation status signal acquiring unit 22, and the distortion compensation unit 25 is stored in the memory 41. A processor 42 of the computer executes the program stored in the memory 41.

FIG. 2 illustrates an example in which each of the constituent elements of the distortion compensation device 2 is implemented by dedicated hardware, and FIG. 3 illustrates an example in which the distortion compensation device 2 is implemented by software, firmware, or the like. However, this is merely an example, and some of the constituent elements of the distortion compensation device 2 may be implemented by dedicated hardware, and the remaining constituent elements may be implemented by software, firmware, or the like.

Next, an operation of the distortion compensation device 2 illustrated in FIG. 1 will be described.

The signal generating unit 1 generates an amplification target signal S which is a signal to be power-amplified. The amplification target signal S includes, for example, an I signal which is an in-phase signal and a Q signal which is a quadrature signal.

Hereinafter, the I signal at time (t) generated by the signal generating unit 1 is represented by I_{IN}(t), and the Q signal at time (t) is represented by Q_{IN}(t).

The signal generating unit 1 outputs the amplification target signal S to the distortion compensation device 2.

In the distortion compensation device 2 illustrated in FIG. 1, the signal generating unit 1 generates the amplification target signal S including the I signal and the Q signal. However, the amplification target signal S may be any signal that can be amplified by the power amplifier 4, and may be a signal not including the I signal and the Q signal.

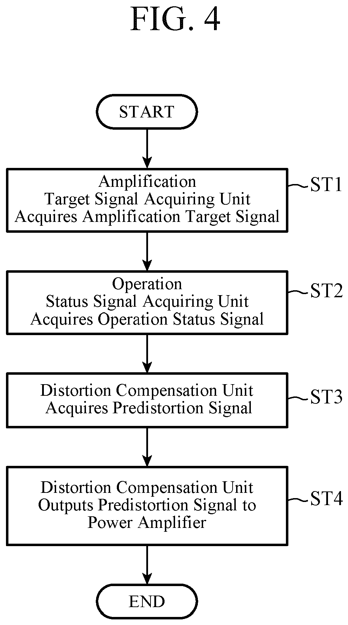

FIG. 4 is a flowchart illustrating a distortion compensation method which is a processing procedure performed by the distortion compensation device 2.

The amplification target signal acquiring unit 21 of the distortion compensation device 2 acquires the amplification target signal S from the signal generating unit 1 (step ST1 in FIG. 4).

The amplification target signal acquiring unit 21 outputs the amplification target signal S to the distortion compensation unit 25.

The operation status signal acquiring unit 22 acquires an operation status signal OC indicating an operation status of the power amplifier 4 (step ST2 in FIG. 4).

The operation status signal acquiring unit 22 outputs the operation status signal OC to the distortion compensation unit 25.

When the operation status signal OC is, for example, temperature information indicating an ambient temperature of the power amplifier 4, the operation status signal acquiring unit 22 acquires the operation status signal OC from a temperature sensor that observes the ambient temperature of the power amplifier 4.

When the operation status signal OC is, for example, frequency information indicating a carrier frequency of the amplification target signal, the operation status signal acquiring unit 22 acquires the operation status signal OC from a control device that controls the transmission device.

In the distortion compensation device 2 illustrated in FIG. 1, the operation status signal acquiring unit 22 acquires one operation status signal OC and outputs the one operation status signal OC to the distortion compensation unit 25. However, this is merely an example, and the operation status signal acquiring unit 22 may obtain two or more operation status signals OC and output the two or more operation status signals OC to the distortion compensation unit 25.

The distortion compensation unit 25 acquires the amplification target signal S from the amplification target signal acquiring unit 21, and acquires the operation status signal OC from the operation status signal acquiring unit 22. In the distortion compensation device 2 illustrated in FIG. 1, the amplification target signal S includes I_{IN}(t) and Q_{IN}(t).

The distortion compensation unit 25 gives each of I_{IN}(t), Q_{IN}(t), and the operation status signal OC to the learning model 24.

The distortion compensation unit 25 acquires, from the learning model 24, a predistortion signal for compensating distortion generated in an amplification target signal S' after power amplification by the power amplifier 4 (step ST3 in FIG. 4).

The predistortion signal is a signal in which distortion is added to the amplification target signal S in order to eliminate distortion generated in the amplification target signal S' after power amplification by the power amplifier 4. Generally, the distortion added to the amplification target signal S is distortion having a characteristic opposite to the distortion generated in the amplification target signal S' after power amplification by the power amplifier 4.

The predistortion signal output from the learning model 24 includes I_{OUT}(t) and Q_{OUT}(t).

The distortion compensation unit 25 outputs the predistortion signal including I_{OUT}(t) and Q_{OUT}(t) to the power amplifier 4 via the DAC 3 (step ST4 in FIG. 4).

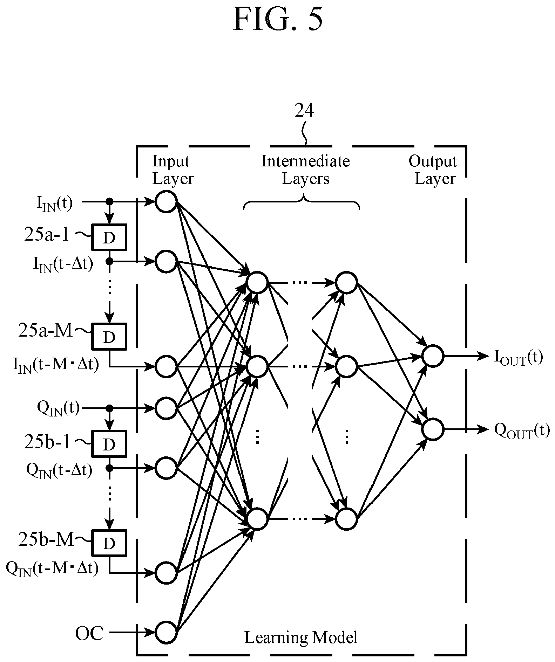

FIG. 5 is an explanatory diagram illustrating configuration examples of the distortion compensation unit 25 and the learning model 24.

In FIG. 5, the distortion compensation unit 25 includes M first delayers 25a-m and M second delayers 25b-m. m = 1, ···, M, and M is an integer equal to or more than 2. In FIG. 5, each of the first delayers 25a-m and the second delayers 25b-m is denoted as "D". Here, it is assumed that a sampling interval of the distortion compensation unit 25 is Δt.

I_{IN}(t) at time (t) is given to any one of a plurality of input layers of the learning model 24. A first delayer 25a-1 delays I_{IN}(t) at time (t) by one sampling time Δt.

I_{IN}(t-Δt), which is an output signal of the first delayer 25a-1, is obtained by delaying a signal given before one sampling time by Δt, and is given to any one of the plurality of input layers. In addition, I_{IN}(t-Δt) is given to a first delayer 25a-2.

A first delayer 25a-m (m=2, ···, M) delays I_{IN}(t-(m-1)•Δt), which is an output signal of a first delayer 25a-(m-1), by one sampling time Δt.

I_{IN}(t-m•Δt), which is an output signal of the first delayer 25a-m, is obtained by delaying a signal given before one sampling time by Δt, and is given to any one of the plurality of input layers. In addition, I_{IN}(t-m•Δt) is given to a first delayer 25a-(m+1). Note that, when m = M, I_{IN}(t-m•Δt) is not given to the first delayer 25a-(m+1).

Q_{IN}(t) at time (t) is given to any one of the plurality of input layers of the learning model 24. A second delayer 25b-1 delays Q_{IN}(t) at time (t) by one sampling time Δt.

Q_{IN}(t-Δt), which is an output signal of the second delayer 25b-1, is obtained by delaying a signal given before one sampling time by Δt, and is given to any one of the plurality of input layers. In addition, Q_{IN}(t-Δt) is given to a second delayer 25b-2.

A second delayer 25b-m (m=2, ···, M) delays Q_{IN}(t-(m-1)•Δt), which is an output signal of a second delayer 25b-(m-1), by one sampling time Δt.

Q_{IN}(t-m•Δt), which is an output signal of the second delayer 25b-m, is obtained by delaying a signal given before one sampling time by Δt, and is given to any one of the plurality of input layers. In addition, Q_{IN}(t-m•Δt) is given to a second delayer 25b-(m+1). Note that, when m = M, Q_{IN}(t-m•Δt) is not given to the second delayer 25b-(m+1).

Among the plurality of input layers of the learning model 24, the operation status signal OC is given to an input layer other than an input layer to which I_{IN}(t), I_{IN}(t-m•Δt), Q_{IN}(t), or Q_{IN}(t-m•Δt) is given. As the operation status signal OC, for example, an operation status signal OC indicating temperature information, an operation status signal OC indicating frequency information, an operation status signal OC indicating bias information, or an operation status signal OC indicating backoff information is given to an input layer.

A signal given to an input layer of the learning model 24 is propagated to each of a plurality of intermediate layers in the learning model 24. Weight addition of the plurality of signals propagated to each of the intermediate layers is performed on the basis of a weighting factor determined by learning of the predistortion signal included in the training data.

The signal subjected to the weight addition in each of the intermediate layers is propagated to each of two output layers. Weight addition of the plurality of signals propagated to each of the output layers is performed on the basis of a weighting factor determined by learning of the predistortion signal included in the training data.

The signal subjected to weight addition in each of the output layers is an amplification target signal after distortion addition. The amplification target signal after distortion addition is a predistortion signal including I_{OUT}(t) and Q_{OUT}(t).

To an input layer of the learning model 24 illustrated in FIG. 5, not only I_{IN}(t) and Q_{IN}(t) at a current time t but also I_{IN}(t-m•Δt) and Q_{1N}(t-m•Δt) (m = 1, ···, M) are given. Therefore, learning of the predistortion signal is performed in consideration of a change in a time-series signal including a current signal and a past signal. Therefore, the distortion compensation unit 25 can acquire the predistortion signal corresponding to a temporal change of the amplification target signal S from the learning model 24.

Note that the input layer of the learning model 24 is not limited to one to which a time-series signal is given, and may be one to which only I_{IN}(t) and Q_{IN}(t) are given.

The DAC 3 acquires the predistortion signal, which is an amplification target signal after distortion addition, from the distortion compensation device 2.

The DAC 3 converts the predistortion signal output from a digital signal to an analog signal.

The DAC 3 outputs the analog predistortion signal to the power amplifier 4.

The power amplifier 4 acquires the analog predistortion signal from the distortion compensation device 2.

The power amplifier 4 amplifies power of the analog predistortion signal, and outputs the predistortion signal after power amplification to the transmission antenna 5.

The predistortion signal is an amplification target signal to which distortion is added in order to compensate distortion generated in a signal after power amplification by the power amplifier 4. Therefore, the transmission signal, which is a signal after power amplification by the power amplifier 4, is a signal in which little distortion is generated.

The power amplifier 4 outputs the transmission signal after power amplification to the transmission antenna 5.

The transmission antenna 5 emits a radio wave related to the transmission signal output from the power amplifier 4 into space.

In the first embodiment described above, the distortion compensation device 2 includes the amplification target signal acquiring unit 21 that acquires an amplification target signal which is a signal to be power-amplified by the power amplifier 4 and the operation status signal acquiring unit 22 that acquires an operation status signal indicating an operation status of the power amplifier 4. In addition, the distortion compensation device 2 includes the distortion compensation unit 25 that estimates a signal in which distortion is added to the amplification target signal acquired by the amplification target signal acquiring unit 21 as a predistortion signal for compensating distortion generated in the amplification target signal after power amplification by the power amplifier 4 on the basis of the amplification target signal acquired by the amplification target signal acquiring unit 21 and the operation status signal acquired by the operation status signal acquiring unit 22, and outputs the predistortion signal to the power amplifier 4. Therefore, even when an operation status of the power amplifier 4 changes, the distortion compensation device 2 can compensate distortion generated in a signal after power amplification by the power amplifier 4.

### Second Embodiment.

In a second embodiment, a distortion compensation device 2 including a learning processing unit 26 that gives training data to a learning model 24 and causes the learning model 24 to learn a predistortion signal included in the training data will be described.

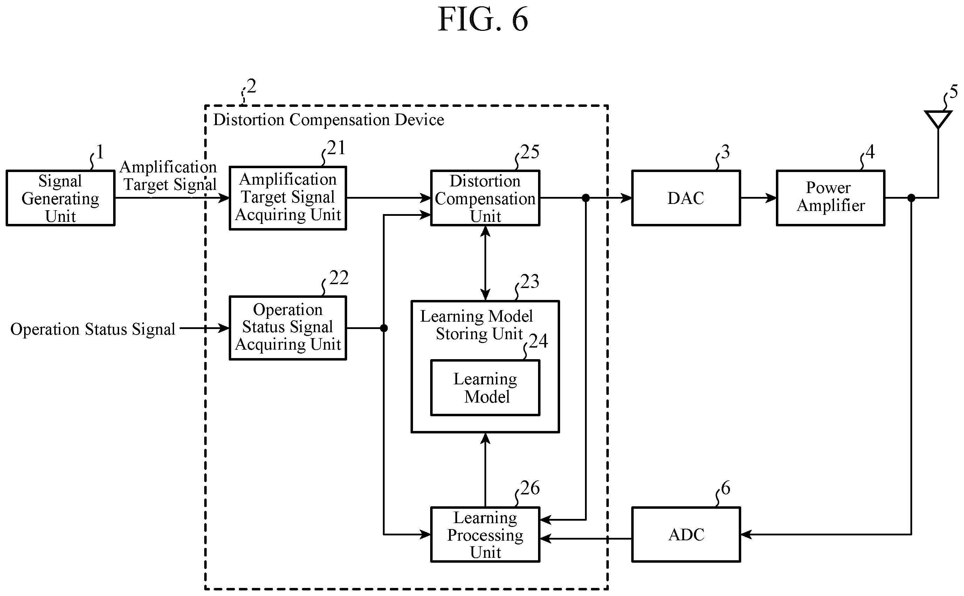

FIG. 6 is a configuration diagram illustrating a transmission device including the distortion compensation device 2 according to the second embodiment. In FIG. 6, the same reference numerals as in FIG. 1 indicate the same or corresponding parts, and therefore description thereof is omitted.

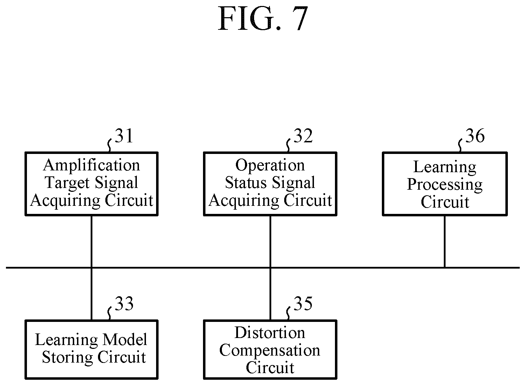

FIG. 7 is a hardware configuration diagram illustrating hardware of the distortion compensation device 2 according to the second embodiment. In FIG. 7, the same reference numerals as in FIG. 2 indicate the same or corresponding parts, and therefore description thereof is omitted.

The transmission device illustrated in FIG. 6 includes a signal generating unit 1, the distortion compensation device 2, a DAC 3, a power amplifier 4, a transmission antenna 5, and an analog-to-digital converter (hereinafter, referred to as "ADC") 6.

The ADC 6 converts an amplification target signal after power amplification by the power amplifier 4 from an analog signal to a digital signal.

The ADC 6 outputs the digital amplification target signal to the distortion compensation device 2.

The distortion compensation device 2 illustrated in FIG. 6 includes an amplification target signal acquiring unit 21, an operation status signal acquiring unit 22, a learning model storing unit 23, a distortion compensation unit 25, and a learning processing unit 26.

The learning processing unit 26 is implemented by, for example, a learning processing circuit 36 illustrated in FIG. 7.

The learning processing unit 26 acquires training data to be given to the learning model 24.

The training data acquired by the learning processing unit 26 includes the digital amplification target signal output from the ADC 6, an operation status signal acquired by the operation status signal acquiring unit 22, and a predistortion signal output from the distortion compensation unit 25. The digital amplification target signal output from the ADC 6 corresponds to an amplification target signal after power amplification by the power amplifier 4. The predistortion signal included in the training data is a signal used as a teacher signal.

The learning processing unit 26 gives the training data to the learning model 24 and causes the learning model 24 to learn the predistortion signal included in the training data.

In FIG. 6, it is assumed that each of the amplification target signal acquiring unit 21, the operation status signal acquiring unit 22, the learning model storing unit 23, the distortion compensation unit 25, and the learning processing unit 26, which are constituent elements of the distortion compensation device 2, is implemented by dedicated hardware as illustrated in FIG. 7. That is, it is assumed that the distortion compensation device 2 is implemented by the amplification target signal acquiring circuit 31, the operation status signal acquiring circuit 32, the learning model storing circuit 33, the distortion compensation circuit 35, and the learning processing circuit 36.

To each of the amplification target signal acquiring circuit 31, the operation status signal acquiring circuit 32, the distortion compensation circuit 35, and the learning processing circuit 36, for example, a single circuit, a composite circuit, a programmed processor, a parallel programmed processor, an ASIC, a FPGA, or a combination thereof corresponds.

The constituent elements of the distortion compensation device 2 are not limited to those implemented by dedicated hardware, and the distortion compensation device 2 may be implemented by software, firmware, or a combination of software and firmware.

In a case where the distortion compensation device 2 is implemented by software, firmware, or the like, the learning model storing unit 23 is constituted on a memory 41 illustrated in FIG. 3. A program for causing a computer to execute a processing procedure performed in each of the amplification target signal acquiring unit 21, the operation status signal acquiring unit 22, the distortion compensation unit 25, and the learning processing unit 26 is stored in the memory 41. A processor 42 illustrated in FIG. 3 executes the program stored in the memory 41.

FIG. 7 illustrates an example in which each of the constituent elements of the distortion compensation device 2 is implemented by dedicated hardware, and FIG. 3 illustrates an example in which the distortion compensation device 2 is implemented by software, firmware, or the like. However, this is merely an example, and some of the constituent elements of the distortion compensation device 2 may be implemented by dedicated hardware, and the remaining constituent elements may be implemented by software, firmware, or the like.

Next, an operation of the distortion compensation device 2 illustrated in FIG. 6 will be described. Components other than the learning processing unit 26 are similar to those of the distortion compensation device 2 illustrated in FIG. 1, and therefore an operation of the learning processing unit 26 will be mainly described here.

Most of power of the amplification target signal after power amplification by the power amplifier 4 is output to the transmission antenna 5, and a part of the power of the amplification target signal is output to the ADC 6.

The ADC 6 converts an amplification target signal after power amplification by the power amplifier 4 from an analog signal to a digital signal.

The ADC 6 outputs the digital amplification target signal to the distortion compensation device 2.

The learning processing unit 26 acquires training data to be given to the learning model 24.

That is, the learning processing unit 26 acquires, as the training data, the digital amplification target signal output from the ADC 6, the operation status signal OC output from the operation status signal acquiring unit 22, and the predistortion signal output from the distortion compensation unit 25.

The learning processing unit 26 gives the training data to the learning model 24 and causes the learning model 24 to learn the predistortion signal included in the training data.

When the amplification target signal S acquired by the amplification target signal acquiring unit 21 and the operation status signal OC acquired by the operation status signal acquiring unit 22 are given to the trained learning model 24, the trained learning model 24 outputs a predistortion signal corresponding to each of the amplification target signal S and the operation status signal OC.

The distortion compensation unit 25 acquires the amplification target signal S from the amplification target signal acquiring unit 21, and acquires the operation status signal OC from the operation status signal acquiring unit 22. The amplification target signal S includes I_{IN}(t) and Q_{IN}(t).

The distortion compensation unit 25 gives each of I_{IN}(t), Q_{IN}(t), and the operation status signal OC to the trained learning model 24.

The distortion compensation unit 25 acquires, from the learning model 24, a predistortion signal for compensating distortion generated in an amplification target signal S' after power amplification by the power amplifier 4.

In the second embodiment described above, the distortion compensation device 2 includes the learning processing unit 26 that acquires, as training data, an amplification target signal after power amplification by the power amplifier 4, an operation status signal acquired by the operation status signal acquiring unit 22, and a predistortion signal output from the distortion compensation unit 25, gives the training data to the learning model 24, and causes the learning model 24 to learn the predistortion signal. Therefore, even when an operation status of the power amplifier 4 changes, the distortion compensation device 2 can compensate distortion generated in a signal after power amplification by the power amplifier 4, and can cause the learning model 24 to learn the predistortion signal.

### Third Embodiment.

In a third embodiment, a distortion compensation device 2 including a signal value adjusting unit 27 that adjusts a signal value of an operation status signal OC will be described.

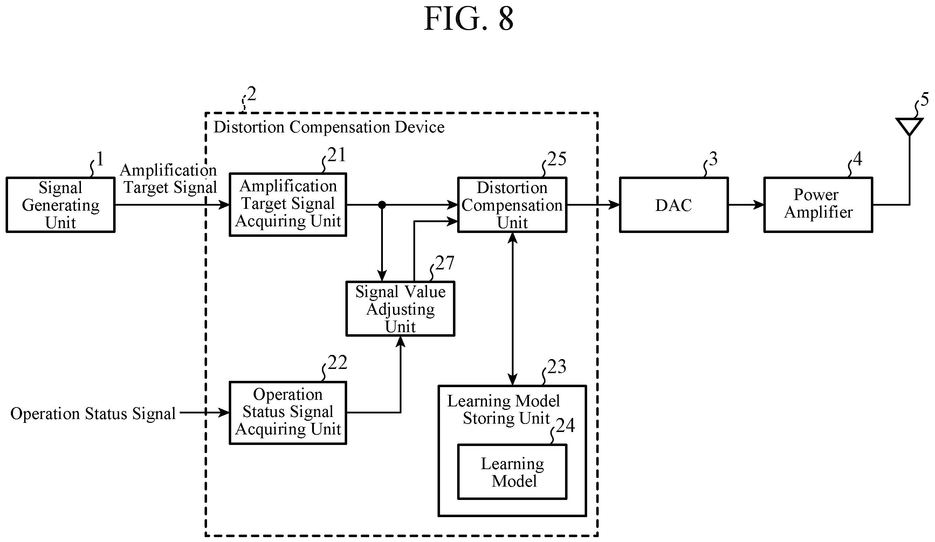

FIG. 8 is a configuration diagram illustrating a transmission device including the distortion compensation device 2 according to the third embodiment. In FIG. 8, the same reference numerals as in FIGS. 1 and 6 indicate the same or corresponding parts, and therefore description thereof is omitted.

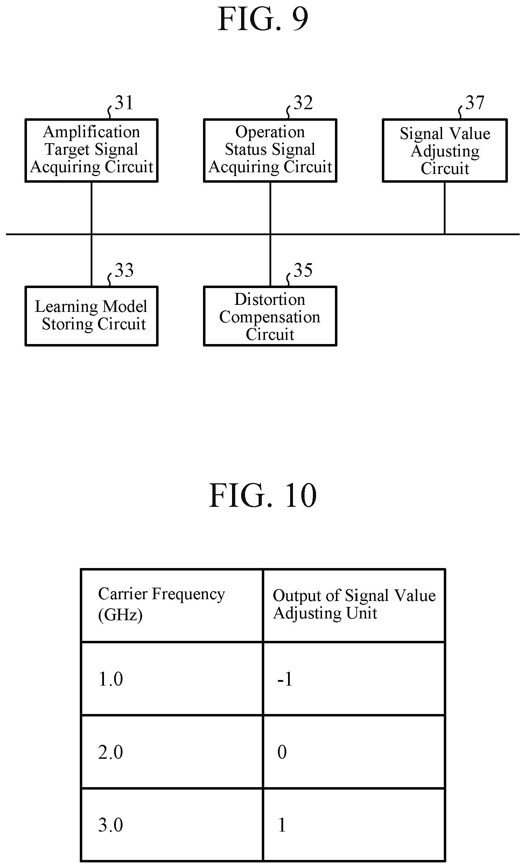

FIG. 9 is a hardware configuration diagram illustrating hardware of the distortion compensation device 2 according to the third embodiment. In FIG. 9, the same reference numerals as in FIGS. 2 and 7 indicate the same or corresponding parts, and therefore description thereof is omitted.

The signal value adjusting unit 27 is implemented by, for example, a signal value adjusting circuit 37 illustrated in FIG. 9.

The signal value adjusting unit 27 adjusts a signal value of an operation status signal OC acquired by an operation status signal acquiring unit 22 in such a manner that a signal change width of the operation status signal OC is equal to a signal change width of an amplification target signal S acquired by an amplification target signal acquiring unit 21.

The signal value adjusting unit 27 outputs an operation status signal OC' after signal value adjustment to a distortion compensation unit 25.

In the distortion compensation device 2 illustrated in FIG. 8, the signal value adjusting unit 27 is applied to the distortion compensation device 2 illustrated in FIG. 1. However, this is merely an example, and the signal value adjusting unit 27 may be applied to the distortion compensation device 2 illustrated in FIG. 6.

In FIG. 8, it is assumed that each of the amplification target signal acquiring unit 21, the operation status signal acquiring unit 22, a learning model storing unit 23, the signal value adjusting unit 27, and the distortion compensation unit 25, which are constituent elements of the distortion compensation device 2, is implemented by dedicated hardware as illustrated in FIG. 9. That is, it is assumed that the distortion compensation device 2 is implemented by an amplification target signal acquiring circuit 31, an operation status signal acquiring circuit 32, a learning model storing circuit 33, the signal value adjusting circuit 37, and a distortion compensation circuit 35.

To each of the amplification target signal acquiring circuit 31, the operation status signal acquiring circuit 32, the signal value adjusting circuit 37, and the distortion compensation circuit 35, for example, a single circuit, a composite circuit, a programmed processor, a parallel programmed processor, an ASIC, an FPGA, or a combination thereof corresponds.

The constituent elements of the distortion compensation device 2 are not limited to those implemented by dedicated hardware, and the distortion compensation device 2 may be implemented by software, firmware, or a combination of software and firmware.

In a case where the distortion compensation device 2 is implemented by software, firmware, or the like, the learning model storing unit 23 is constituted on a memory 41 illustrated in FIG. 3. A program for causing a computer to execute a processing procedure performed in each of the amplification target signal acquiring unit 21, the operation status signal acquiring unit 22, the signal value adjusting unit 27, and the distortion compensation unit 25 is stored in the memory 41. A processor 42 illustrated in FIG. 3 executes the program stored in the memory 41.

FIG. 9 illustrates an example in which each of the constituent elements of the distortion compensation device 2 is implemented by dedicated hardware, and FIG. 3 illustrates an example in which the distortion compensation device 2 is implemented by software, firmware, or the like. However, this is merely an example, and some of the constituent elements of the distortion compensation device 2 may be implemented by dedicated hardware, and the remaining constituent elements may be implemented by software, firmware, or the like.

Next, an operation of the distortion compensation device 2 illustrated in FIG. 8 will be described. Components other than the signal value adjusting unit 27 are similar to those of the distortion compensation device 2 illustrated in FIG. 1, and therefore an operation of the signal value adjusting unit 27 will be mainly described here.

The signal value adjusting unit 27 acquires the amplification target signal S from the amplification target signal acquiring unit 21, and acquires the operation status signal OC from the operation status signal acquiring unit 22.

The signal value adjusting unit 27 adjusts a signal value of the operation status signal OC in such a manner that a signal change width of the operation status signal OC is equal to a signal change width of the amplification target signal S.

For example, in a case where the operation status signal OC is frequency information indicating a carrier frequency of the amplification target signal S and the signal change width of the carrier frequency is 1.0 [GHz] to 3.0 [GHz] as illustrated in FIG. 10, when an upper limit value of the signal value of the amplification target signal S is "1" and a lower limit value of the signal value of the amplification target signal S is "-1", the signal value adjusting unit 27 adjusts the signal value of the operation status signal OC as follows.

FIG. 10 is an explanatory diagram illustrating details of signal value adjustment performed by the signal value adjusting unit 27.

When the signal value of the operation status signal OC acquired from the operation status signal acquiring unit 22 is, for example, "3.0" as the upper limit value, the signal value adjusting unit 27 adjusts the signal value of the operation status signal OC to "1" in such a manner that the signal value is equal to the upper limit value "1" of the signal value of the amplification target signal S.

When the signal value of the operation status signal OC acquired from the operation status signal acquiring unit 22 is, for example, "1.0" as the lower limit value, the signal value adjusting unit 27 adjusts the signal value of the operation status signal OC to "-1" in such a manner that the signal value is equal to the lower limit value "-1" of the signal value of the amplification target signal S.

When the signal value of the operation status signal OC acquired from the operation status signal acquiring unit 22 is, for example, "2.0" as a median value, the signal value adjusting unit 27 adjusts the signal value of the operation status signal OC to "0" in such a manner that the signal value is equal to the median value "0" of the signal value of the amplification target signal S.

The signal value adjusting unit 27 outputs the operation status signal OC' after signal value adjustment to the distortion compensation unit 25.

Here, an example is illustrated in which the operation status signal OC is frequency information indicating a carrier frequency of the amplification target signal. However, this is merely an example, and the operation status signal OC may be temperature information indicating an ambient temperature of the power amplifier 4, bias voltage information indicating a bias voltage of the power amplifier 4, or backoff information indicating backoff of the power amplifier 4. Also in this case, the signal value adjusting unit 27 adjusts the signal value of the operation status signal OC similarly to the frequency information indicating a carrier frequency.

The distortion compensation unit 25 acquires the amplification target signal S from the amplification target signal acquiring unit 21, and acquires the operation status signal OC' after signal value adjustment from the signal value adjusting unit 27. The amplification target signal includes I_{IN}(t) and Q_{IN}(t).

The distortion compensation unit 25 gives each of I_{IN}(t), Q_{IN}(t), and the operation status signal OC' to the trained learning model 24.

In the learning model 24, at the time of training, an upper limit of a weight for the amplification target signal S in a neural network is the same as an upper limit of a weight for the operation status signal OC' in the neural network by the operation status signal OC' after signal value adjustment being given to the learning model 24. Therefore, biased learning in which the amplification target signal S is emphasized more than the operation status signal OC is prevented. In addition, biased learning in which the operation status signal OC is emphasized more than the amplification target signal S is prevented. That is, the amplification target signal S and the operation status signal OC' are learned with a similar weight. As a result, predistortion signal learning accuracy by the learning model 24 is improved.

In addition, even when the distortion compensation unit 25 acquires the predistortion signal from the learning model 24, the distortion compensation unit 25 can acquire a predistortion signal with high distortion compensation accuracy.

In the third embodiment described above, the distortion compensation device 2 illustrated in FIG. 8 includes the signal value adjusting unit 27 that adjusts a signal value of an operation status signal acquired by the operation status signal acquiring unit 22 in such a manner that a signal change width of the operation status signal is equal to a signal change width of an amplification target signal acquired by the amplification target signal acquiring unit 21, and outputs the operation status signal after signal value adjustment to the distortion compensation unit 25. Therefore, even when an operation status of the power amplifier 4 changes, the distortion compensation device 2 illustrated in FIG. 8 can compensate distortion generated in a signal after power amplification by the power amplifier 4, and can compensate distortion with higher accuracy than the distortion compensation device 2 illustrated in FIG. 1.

Each of the transmission device illustrated in FIG. 1 and the transmission device illustrated in FIG. 8 includes the signal generating unit 1, the distortion compensation device 2, the DAC 3, the power amplifier 4, and the transmission antenna 5. The transmission device illustrated in FIG. 6 includes the signal generating unit 1, the distortion compensation device 2, the DAC 3, the power amplifier 4, the transmission antenna 5, and the ADC 6.

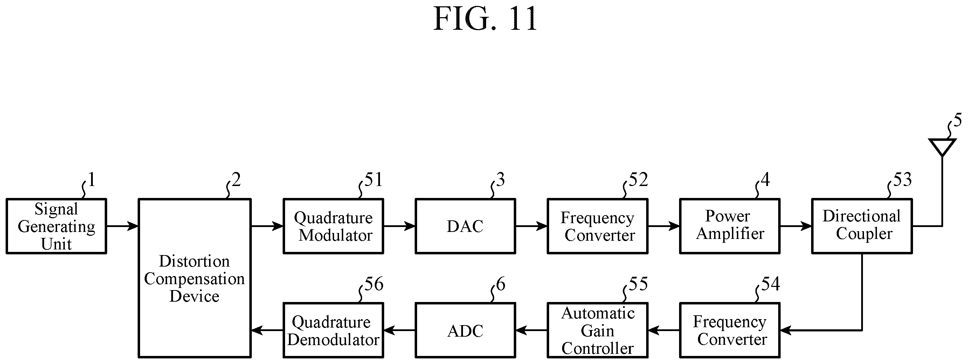

However, these are merely examples, and the transmission device may include the signal generating unit 1, the distortion compensation device 2, a quadrature modulator 51, the DAC 3, a frequency converter 52, the power amplifier 4, a directional coupler 53, the transmission antenna 5, a frequency converter 54, an automatic gain controller 55, the ADC 6, and a quadrature demodulator 56 as illustrated in FIG. 11.

FIG. 11 is a configuration diagram illustrating an example of a transmission device including the distortion compensation device 2.

In FIG. 11, for convenience of description, it is assumed that the signal generating unit 1 generates an IF baseband signal as an amplification target signal.

The quadrature modulator 51 performs quadrature modulation on a baseband signal after distortion addition, which is a predistortion signal output from the distortion compensation device 2, using a carrier signal.

The quadrature modulator 51 outputs a transmission signal, which is a baseband signal after quadrature modulation, to the DAC 3.

The frequency converter 52 converts a frequency of the analog transmission signal output from the DAC 3 to, for example, RF.

The frequency converter 52 outputs the transmission signal having a frequency of RF to the power amplifier 4.

The directional coupler 53 divides the transmission signal after power amplification by the power amplifier 4 into two.

The directional coupler 53 outputs one of the two transmission signals after division to the transmission antenna 5 and outputs the other transmission signal to the frequency converter 54.

The frequency converter 54 converts a frequency of the transmission signal output from the directional coupler 53 to, for example, IF.

The frequency converter 54 outputs the transmission signal having a frequency of IF to the automatic gain controller 55.

The automatic gain controller 55 controls a gain of the transmission signal output from the frequency converter 54.

The automatic gain controller 55 outputs the transmission signal after gain control to the ADC 6
The quadrature demodulator 56 performs quadrature demodulation on the digital transmission signal output from the ADC 6 using a carrier signal.

The quadrature demodulator 56 outputs a baseband signal, which is the transmission signal after quadrature demodulation, to the distortion compensation device 2.

### INDUSTRIAL APPLICABILITY

The present disclosure is suitable for a distortion compensation device, a distortion compensation method, and a transmission device.

### REFERENCE SIGNS LIST

1: signal generating unit, 2: distortion compensation device, 3: DAC, 4: power amplifier, 5: transmission antenna, 6: ADC, 21: amplification target signal acquiring unit, 22: operation status signal acquiring unit, 23: learning model storing unit, 24: learning model, 25: distortion compensation unit, 25a-1 to 25a-M: first delayer, 25b-1 to 25b-M: second delayer, 26: learning processing unit, 27: signal value adjusting unit, 31: amplification target signal acquiring circuit, 32: operation status signal acquiring circuit, 33: learning model storing circuit, 35: distortion compensation circuit, 36: learning processing circuit, 37: signal value adjusting circuit, 41: memory, 42: processor, 51: quadrature modulator, 52: frequency converter, 53: directional coupler, 54: frequency converter, 55: automatic gain controller, 56: quadrature demodulator

## Claims

1. A distortion compensation device (2) comprising:
an amplification target signal acquiring unit (21) to acquire an amplification target signal which is a signal to which power amplification by a power amplifier (4) is performed,
an operation status signal acquiring unit (22) to acquire an operation status signal indicating an operation status of the power amplifier; and
a distortion compensation unit (25) to acquire a signal in which distortion is added to the amplification target signal acquired by the amplification target signal acquiring unit as a predistortion signal for performing compensation of distortion generated in the amplification target signal after the power amplification by the power amplifier on a basis of the amplification target signal acquired by the amplification target signal acquiring unit and the operation status signal acquired by the operation status signal acquiring unit, and to output the predistortion signal to the power amplifier,
wherein the distortion compensation unit gives, when the amplification target signal and the operation status signal are input, the amplification target signal acquired by the amplification target signal acquiring unit and the operation status signal acquired by the operation status signal acquiring unit to a learning model being trained to output a signal to which distortion for compensating distortion generated in the amplification target signal after the power amplification is performed, and acquires the predistortion signal estimated by the learning model without training the learning model,
the learning model is implemented by a neural network, and in training, a time-series signal of the amplification target signal acquired by the amplification target signal acquiring unit, the operation status signal acquired by the operation status signal acquiring unit, and the predistortion signal are given to the learning model as training data,
the learning model is trained to output the predistortion signal corresponding to the time-series signal of the amplification target signal and the operation status signal which have been input by calculating a weight addition of the time-series signal of the amplification target signal and the operation status signal on a basis of weight coefficients determined by learning of the predistortion signal included in the training data, and
the distortion compensation unit generates, when the amplification target signal is input, a time-series signal of the amplification target signal by sequentially delaying the amplification target signal by a predetermined sampling time, gives the time-series signal of the amplification target signal being generated and the operation status signal to the learning model, and acquires the predistortion signal estimated by the learning model.

2. The distortion compensation device (2) according to claim 1, wherein
the learning model is trained using at least two of temperature information, frequency information, bias inf9ormation, and backoff information.

3. The distortion compensation device (2) according to claim 2, further comprising a learning processing unit (26) to acquire, as training data, the amplification target signal after the power amplification by the power amplifier, the operation status signal acquired by the operation status signal acquiring unit, and the predistortion signal output from the distortion compensation unit, to give the training data to the learning model (24), and to cause the learning model to learn the predistortion signal.

4. The distortion compensation device (2) according to claim 1, further comprising a signal value adjusting unit (27) to perform adjustment of a signal value of the operation status signal acquired by the operation status signal acquiring unit (22) in such a manner that a signal change width of the operation status signal is equal to a signal change width of the amplification target signal acquired by the amplification target signal acquiring unit (21), and to output the operation status signal after the adjustment to the distortion compensation unit (25).

5. The distortion compensation device (2) according to claim 1, wherein
the operation status signal acquiring unit (22) is configured to acquire, as the operation status signal, temperature information indicating an ambient temperature of the power amplifier (4), frequency information indicating a carrier frequency of the amplification target signal acquired by the amplification target signal acquiring unit (21), bias voltage information indicating a bias voltage of the power amplifier, or backoff information indicating backoff of the power amplifier.

6. A distortion compensation method comprising:
acquiring, by an amplification target signal acquiring unit (21), an amplification target signal which is a signal to which power amplification by a power amplifier (4) is performed;
acquiring, by an operation status signal acquiring unit (22), an operation status signal indicating an operation status of the power amplifier (4); and
acquiring, by a distortion compensation unit (25), a signal in which distortion is added to the amplification target signal acquired by the amplification target signal acquiring unit as a predistortion signal for performing compensation of distortion generated in the amplification target signal after the power amplification by the power amplifier on a basis of the amplification target signal acquired by the amplification target signal acquiring unit and the operation status signal acquired by the operation status signal acquiring unit, and outputting, by the distortion compensation unit, the predistortion signal to the power amplifier;
wherein the distortion compensation unit gives, when the amplification target signal and the operation status signal are input, the amplification target signal acquired by the amplification target signal acquiring unit and the operation status signal acquired by the operation status signal acquiring unit to a learning model being trained to output a signal to which distortion for compensating distortion generated in the amplification target signal after the power amplification is performed, and acquires the predistortion signal estimated by the learning model without training the learning model,
the learning model is implemented by a neural network, and in training, a time-series signal of the amplification target signal acquired by the amplification target signal acquiring unit, the operation status signal acquired by the operation status signal acquiring unit, and the predistortion signal are given to the learning model as training data,
the learning model is trained to output the predistortion signal corresponding to the time-series signal of the amplification target signal and the operation status signal which have been input by calculating a weight addition of the time-series signal of the amplification target signal and the operation status signal on a basis of weight coefficients determined by learning of the predistortion signal included in the training data, and
the distortion compensation unit generates, when the amplification target signal is input, a time-series signal of the amplification target signal by sequentially delaying the amplification target signal by a predetermined sampling time, gives the time-series signal of the amplification target signal being generated and the operation status signal to the learning model, and acquires the predistortion signal estimated by the learning model.

7. A transmission device comprising:
the power amplifier (4) and
the distortion compensation device (2) according to claim 1.

## Patentansprüche

1. Verzerrungskompensationseinrichtung (2), umfassend:
eine Verstärkungszielsignal-Beschaffungseinheit (21) zum Beschaffen eines Verstärkungszielsignals, das ein Signal ist, an dem eine Leistungsverstärkung durch einen Leistungsverstärker (4) durchgeführt wird,
eine Betriebsstatussignal-Beschaffungseinheit (22) zum Beschaffen eines Betriebsstatussignals, das einen Betriebsstatus des Leistungsverstärkers angibt; und
eine Verzerrungskompensationseinheit (25) zum Beschaffen eines Signals, in dem eine Verzerrung zu dem von der Verstärkungszielsignal-Beschaffungseinheit beschafften Verstärkungszielsignal hinzugefügt wird, als ein Vorverzerrungssignal zum Durchführen einer Kompensation einer in dem Verstärkungszielsignal nach der Leistungsverstärkung durch den Leistungsverstärker erzeugten Verzerrung auf der Grundlage des von der Verstärkungszielsignal-Beschaffungseinheit beschafften Verstärkungszielsignals und des von der Betriebsstatussignal-Beschaffungseinheit beschafften Betriebsstatussignals, und zum Ausgeben des Vorverzerrungssignals an den Leistungsverstärker,
wobei die Verzerrungskompensationseinheit, wenn das Verstärkungszielsignal und das Betriebsstatussignal eingegeben werden, das von der Verstärkungszielsignal-Beschaffungseinheit beschaffte Verstärkungszielsignal und das von der Betriebsstatussignal-Beschaffungseinheit beschaffte Betriebsstatussignal an ein Lernmodell weitergibt, das trainiert wird, um ein Signal auszugeben, an dem die Verzerrung zum Kompensieren der in dem Verstärkungszielsignal erzeugten Verzerrung nach der Leistungsverstärkung durchgeführt wird, und das von dem Lernmodell ermittelte Vorverzerrungssignal ohne Training des Lernmodells beschafft,
das Lernmodell durch ein neuronales Netzwerk implementiert wird, und beim Training ein Zeitreihensignal des Verstärkungszielsignals, das durch die Verstärkungszielsignal-Beschaffungseinheit beschafft wird, das Betriebsstatussignal, das durch die Betriebsstatussignal-Beschaffungseinheit beschafft wird, und das Vorverzerrungssignal dem Lernmodell als Trainingsdaten gegeben werden,
das Lernmodell trainiert wird, um das Vorverzerrungssignal auszugeben, das dem Zeitreihensignal des Verstärkungszielsignals und dem Betriebsstatussignal entspricht, die eingegeben wurden, indem eine Gewichtungszufügung des Zeitreihensignals des Verstärkungszielsignals und des Betriebsstatussignals auf Grundlage von Gewichtungskoeffizienten berechnet wird, die durch Lernen des in den Trainingsdaten enthaltenen Vorverzerrungssignals bestimmt werden, und
die Verzerrungskompensationseinheit, wenn das Verstärkungszielsignal eingegeben wird, ein Zeitreihensignal des Verstärkungszielsignals erzeugt, indem das Verstärkungszielsignal um eine vorbestimmte Abtastzeit sequentiell verzögert wird, das Zeitreihensignal des erzeugten Verstärkungszielsignals und das Betriebsstatussignal an das Lernmodell gibt und das durch das Lernmodell ermittelte Vorverzerrungssignal beschafft.

2. Verzerrungskompensationseinrichtung (2) nach Anspruch 1, wobei
das Lernmodell unter Verwendung von mindestens zwei von Temperaturinformationen, Frequenzinformationen, Vorspannungsinformationen und Backoff-Informationen trainiert wird.

3. Verzerrungskompensationseinrichtung (2) nach Anspruch 2, ferner umfassend eine Lernverarbeitungseinheit (26), um als Trainingsdaten das Verstärkungszielsignal nach der Leistungsverstärkung durch den Leistungsverstärker, das Betriebsstatussignal, das durch die Betriebsstatussignal-Beschaffungseinheit beschafft wird, und das Vorverzerrungssignal, das von der Verzerrungskompensationseinheit ausgegeben wird, zu beschaffen, um die Trainingsdaten an das Lernmodell (24) zu geben und um das Lernmodell zu veranlassen, das Vorverzerrungssignal zu lernen.

4. Verzerrungskompensationseinrichtung (2) nach Anspruch 1, ferner umfassend eine Signalwert-Anpassungseinheit (27), um eine Anpassung eines Signalwerts des Betriebsstatussignals, das von der Betriebsstatussignal-Beschaffungseinheit (22) beschafft wird, auf eine solche Weise durchzuführen, dass eine Signaländerungsbreite des Betriebsstatussignals gleich einer Signaländerungsbreite des Verstärkungszielsignals ist, das von der Verstärkungszielsignal-Beschaffungseinheit (21) beschafft wird, und um das Betriebsstatussignal nach der Anpassung an die Verzerrungskompensationseinheit (25) auszugeben.

5. Verzerrungskompensationseinrichtung (2) nach Anspruch 1, wobei
die Betriebsstatussignal-Beschaffungseinheit (22) eingerichtet ist, als das Betriebsstatussignal Temperaturinformationen, die eine Umgebungstemperatur des Leistungsverstärkers (4) angeben, Frequenzinformationen, die eine Trägerfrequenz des Verstärkungszielsignals angeben, das von der Verstärkungszielsignal-Beschaffungseinheit (21) beschafft wird, Vorspannungsinformationen, die eine Vorspannung des Leistungsverstärkers angeben, oder Backoff-Informationen, die einen Backoff des Leistungsverstärkers angeben, zu beschaffen.

6. Verzerrungskompensationverfahren, umfassend:
Beschaffen, durch eine Verstärkungszielsignal-Beschaffungseinheit (21), eines Verstärkungszielsignals, das ein Signal ist, an dem eine Leistungsverstärkung durch einen Leistungsverstärker (4) durchgeführt wird;
Beschaffen, durch eine Betriebsstatussignal-Beschaffungseinheit (22), eines Betriebsstatussignals, das einen Betriebsstatus des Leistungsverstärkers (4) angibt; und
Beschaffen, durch eine Verzerrungskompensationseinheit (25), eines Signals, in dem eine Verzerrung zu dem von der Verstärkungszielsignal-Beschaffungseinheit beschafften Verstärkungszielsignal hinzugefügt wird, als ein Vorverzerrungssignal zum Durchführen einer Kompensation einer in dem Verstärkungszielsignal nach der Leistungsverstärkung durch den Leistungsverstärker erzeugten Verzerrung auf der Grundlage des von der Verstärkungszielsignal-Beschaffungseinheit beschafften Verstärkungszielsignals und des von der Betriebsstatussignal-Beschaffungseinheit beschafften Betriebsstatussignals, und Ausgeben, durch die Verzerrungskompensationseinheit, des Vorverzerrungssignals an den Leistungsverstärker;
wobei die Verzerrungskompensationseinheit, wenn das Verstärkungszielsignal und das Betriebsstatussignal eingegeben werden, das von der Verstärkungszielsignal-Beschaffungseinheit beschaffte Verstärkungszielsignal und das von der Betriebsstatussignal-Beschaffungseinheit beschaffte Betriebsstatussignal an ein Lernmodell weitergibt, das trainiert wird, um ein Signal auszugeben, an dem die Verzerrung zum Kompensieren der in dem Verstärkungszielsignal erzeugten Verzerrung nach der Leistungsverstärkung durchgeführt wird, und das von dem Lernmodell ermittelte Vorverzerrungssignal ohne Training des Lernmodells beschafft,
das Lernmodell durch ein neuronales Netzwerk implementiert wird und beim Training ein Zeitreihensignal des Verstärkungszielsignals, das durch die Verstärkungszielsignal-Beschaffungseinheit beschafft wird, das Betriebsstatussignal, das durch die Betriebsstatussignal-Beschaffungseinheit beschafft wird, und das Vorverzerrungssignal dem Lernmodell als Trainingsdaten gegeben werden,
das Lernmodell trainiert wird, um das Vorverzerrungssignal auszugeben, das dem Zeitreihensignal des Verstärkungszielsignals und dem Betriebsstatussignal entspricht, die eingegeben wurden, indem eine Gewichtungszufügung des Zeitreihensignals des Verstärkungszielsignals und des Betriebsstatussignals auf Grundlage von Gewichtungskoeffizienten berechnet wird, die durch Lernen des in den Trainingsdaten enthaltenen Vorverzerrungssignals bestimmt werden, und
die Verzerrungskompensationseinheit, wenn das Verstärkungszielsignal eingegeben wird, ein Zeitreihensignal des Verstärkungszielsignals erzeugt, indem das Verstärkungszielsignal um eine vorbestimmte Abtastzeit sequentiell verzögert wird, das Zeitreihensignal des erzeugten Verstärkungszielsignals und das Betriebsstatussignal an das Lernmodell gibt und das durch das Lernmodell ermittelte Vorverzerrungssignal beschafft.

7. Übertragungseinrichtung, umfassend:
den Leistungsverstärker (4) und
die Verzerrungskompensationseinrichtung (2) nach Anspruch 1.

## Revendications

1. Dispositif de compensation de distorsion (2) comprenant :
une unité d'acquisition du signal cible d'amplification (21) pour acquérir un signal cible d'amplification, qui est un signal sur lequel une amplification de puissance par un amplificateur de puissance (4) est effectuée,
une unité d'acquisition de signal d'état de fonctionnement (22) pour acquérir un signal indiquant l'état de fonctionnement de l'amplificateur de puissance ; et
une unité de compensation de la distorsion (25) pour acquérir un signal dans lequel la distorsion est ajoutée au signal cible d'amplification acquis par l'unité d'acquisition de signal cible d'amplification en tant que signal de prédistorsion destiné à compenser la distorsion générée dans le signal cible d'amplification après l'amplification de puissance par l'amplificateur de puissance, sur une base du signal cible d'amplification acquis par l'unité d'acquisition du signal cible et du signal d'état de fonctionnement acquis par l'unité d'acquisition du signal d'état de fonctionnement, et pour émettre le signal de prédistorsion vers l'amplificateur de puissance,
dans lequel l'unité de compensation de la distorsion fournit, lorsque le signal cible d'amplification et le signal d'état de fonctionnement sont entrés, le signal cible d'amplification acquis par l'unité d'acquisition de signal cible d'amplification ainsi que le signal d'état de fonctionnement acquis par une unité d'acquisition de signal d'état de fonctionnement à un modèle d'apprentissage en cours de formation entraîné pour produire un signal de distorsion visant à compenser la distorsion générée dans le signal cible d'amplification après l'amplification de puissance, et acquiert ensuite le signal de prédistorsion estimé par ce modèle d'apprentissage, sans entraîner le modèle d'apprentissage,
le modèle d'apprentissage est mis en œuvre par un réseau neuronal et, lors de l'apprentissage, un signal temporel du signal cible d'amplification acquis par l'unité d'acquisition de signal cible d'amplification, le signal d'état de fonctionnement acquis par l'unité d'acquisition dudit signal d'état de fonctionnement, ainsi que le signal de prédistorsion sont fournis au modèle d'apprentissage en tant que données d'apprentissage,
le modèle d'apprentissage est entraîné à produire le signal de prédistorsion correspondant au signal temporel du signal cible d'amplification et au signal d'état de fonctionnement qui ont été fournis, en calculant une somme pondérée du signal temporel du signal cible d'amplification et du signal d'état de fonctionnement sur une base de coefficients de pondération déterminés par l'apprentissage du signal de prédistorsion inclus dans les données d'apprentissage, et
l'unité de compensation de la distorsion génère, lorsque le signal cible d'amplification est appliqué, un signal temporel du signal cible d'amplification en retardant de manière séquentielle le signal cible d'amplification d'un temps d'échantillonnage prédéterminé, transmet ce signal temporel du signal cible d'amplification généré et le signal d'état de fonctionnement au modèle d'apprentissage, puis acquiert le signal de prédistorsion estimé par ledit modèle d'apprentissage.

2. Dispositif de compensation de distorsion (2) selon la revendication 1, dans lequel
le modèle d'apprentissage est formé à l'aide d'au moins deux des informations suivantes : température, fréquence, biais et back-off.

3. Dispositif de compensation de distorsion (2) selon la revendication 2, comprenant en outre une unité de traitement d'apprentissage (26) pour acquérir, en tant que données d'apprentissage, le signal cible d'amplification après l'amplification de puissance par l'amplificateur de puissance, le signal d'état de fonctionnement acquis par l'unité d'acquisition du signal d'état de fonctionnement, et le signal de prédistorsion émis par l'unité de compensation de la distorsion, afin de fournir les données d'apprentissage au modèle d'apprentissage (24), et d'amener ce modèle à apprendre le signal de prédistorsion.

4. Dispositif de compensation de distorsion (2) selon la revendication 1, comprenant en outre une unité d'ajustement de la valeur du signal (27) pour effectuer l'ajustement d'une valeur du signal d'état de fonctionnement acquis par l'unité d'acquisition du signal d'état de fonctionnement (22) de manière à ce que la largeur de variation du signal d'état de fonctionnement soit égale à celle du signal cible d'amplification acquis par l'unité d'acquisition du signal cible d'amplification (21), et pour émettre ensuite le signal d'état de fonctionnement ajusté à l'unité de compensation de la distorsion (25).

5. Dispositif de compensation de distorsion (2) selon la revendication 1, dans lequel
l'unité d'acquisition du signal d'état de fonctionnement (22) est configurée pour acquérir, en tant que signal d'état de fonctionnement, des informations de température indiquant une température ambiante de l'amplificateur de puissance (4), des informations de fréquence indiquant une fréquence de porteuse du signal cible d'amplification acquis par l'unité d'acquisition du signal cible d'amplification (21), des informations de tension de polarisation indiquant une tension de polarisation de l'amplificateur de puissance, ou des informations de back-off indiquant la marge d'atténuation de l'amplificateur de puissance.

6. Procédé de compensation de la distorsion comprenant :
l'acquisition, par une unité d'acquisition de signal cible d'amplification (21), d'un signal cible d'amplification qui est un signal auquel est appliquée une amplification de puissance par un amplificateur de puissance (4) ;
l'acquisition, par une unité d'acquisition de signal d'état de fonctionnement (22), d'un signal d'état de fonctionnement indiquant un état de l'amplificateur de puissance (4) ; et
l'acquisition, par une unité de compensation de la distorsion (25), d'un signal dans lequel la distorsion est ajoutée au signal cible d'amplification acquis par l'unité d'acquisition du signal cible d'amplification en tant que signal de prédistorsion pour effectuer la compensation de la distorsion générée dans le signal cible d'amplification après l'amplification de puissance par l'amplificateur de puissance sur la base du signal cible d'amplification acquis par l'unité d'acquisition du signal cible d'amplification et du signal d'état de fonctionnement acquis par l'unité d'acquisition du signal d'état de fonctionnement, et l'émission, par l'unité de compensation de la distorsion, du signal de prédistorsion vers l'amplificateur de puissance ;
dans lequel l'unité de compensation de la distorsion fournit, lorsque le signal cible d'amplification et le signal d'état de fonctionnement sont entrés, le signal cible d'amplification acquis par l'unité d'acquisition de signal cible d'amplification ainsi que le signal d'état de fonctionnement acquis par une unité d'acquisition de signal d'état de fonctionnement à un modèle d'apprentissage en cours de formation entraîné pour produire un signal de distorsion visant à compenser la distorsion générée dans le signal cible d'amplification après l'amplification de puissance, et acquiert ensuite le signal de prédistorsion estimé par ce modèle d'apprentissage, sans entraîner le modèle d'apprentissage,
le modèle d'apprentissage est mis en œuvre par un réseau neuronal et, lors de l'apprentissage, un signal temporel de la cible d'amplification acquis par l'unité d'acquisition correspondante, le signal d'état de fonctionnement acquis par l'unité d'acquisition dudit signal d'état de fonctionnement, ainsi que le signal de prédistorsion sont fournis au modèle d'apprentissage en tant que données d'apprentissage,
le modèle d'apprentissage est entraîné à produire le signal de prédistorsion correspondant au signal temporel du signal cible d'amplification et au signal d'état de fonctionnement qui ont été fournis, en calculant une somme pondérée du signal temporel du signal cible d'amplification et du signal d'état de fonctionnement sur une base de coefficients de pondération déterminés par l'apprentissage du signal de prédistorsion inclus dans les données d'apprentissage, et
l'unité de compensation de la distorsion génère, lorsque le signal cible d'amplification est appliqué, un signal temporel du signal cible d'amplification en retardant de manière séquentielle le signal cible d'amplification d'un temps d'échantillonnage prédéterminé, transmet ce signal temporel du signal cible d'amplification généré et le signal d'état de fonctionnement au modèle d'apprentissage, puis acquiert le signal de prédistorsion estimé par ledit modèle d'apprentissage.

7. Dispositif de transmission comprenant :
l'amplificateur de puissance (4) et
le dispositif de compensation de distorsion (2) selon la revendication 1.
